(19) **Europäisches Patentamt**
**European Patent Office**
**Office européen des brevets**

(11) **EP 0 868 725 B1**

(12) **EUROPÄISCHE PATENTSCHRIFT**

(45) Veröffentlichungstag und Bekanntmachung des Hinweises auf die Patenterteilung:
**02.06.1999 Patentblatt 1999/22**

(21) Anmeldenummer: **96946189.6**

(22) Anmeldetag: **12.12.1996**

(51) Int Cl.6: **G11C 11/419**, G11C 11/409

(86) Internationale Anmeldenummer:
**PCT/DE96/02394**

(87) Internationale Veröffentlichungsnummer:
**WO 97/23878 (03.07.1997 Gazette 1997/29)**

(54) **VERFAHREN ZUM BETRIEB EINER SRAM MOS-TRANSISTOR SPEICHERZELLE**

METHOD OF OPERATING AN SRAM MOS TRANSISTOR STORAGE CELL

PROCEDE D'ACTIONNEMENT D'UNE CELLULE DE MEMOIRE RAM STATIQUE A TRANSISTORS MOS

(84) Benannte Vertragsstaaten:
**DE FR GB IE IT NL**

(30) Priorität: **21.12.1995 DE 19548053**

(43) Veröffentlichungstag der Anmeldung:
**07.10.1998 Patentblatt 1998/41**

(73) Patentinhaber: **SIEMENS AKTIENGESELLSCHAFT**
**80333 München (DE)**

(72) Erfinder:
• **BERTHOLD, Jörg**
**D-81675 München (DE)**
• **DRESEL, Jürgen**
**D-71665 Vaihingen (DE)**

(56) Entgegenhaltungen:
**JP-A- 8 329 681**      **US-A- 4 845 676**
**US-A- 5 040 146**

**Beschreibung**

Mikroelektronische Schaltungen zur Daten- und/oder Signalverarbeitung beinhalten Speicher mit Speicherzellen, die die Speicherung von Daten, Zustandsvariablen u.ä. ermöglichen. Mit zunehmender Verarbeitungsgeschwindigkeit sind die Anforderungen an diese Speicher gewachsen. Insbesondere mußten sowohl die Zugriffszeit auf den Inhalt des Speichers (Lesevorgang) als auch der Zeitraum zum Beschreiben des Speichers (Schreibvorgang) deutlich verkürzt werden. Ein wichtiger Vertreter von derartigen Speichern ist das SRAM (Static Random Access Memory), welches mit einem geringem Flächenbedarf realisiert werden kann und einen sehr schnellen Zugriff auf seinen Inhalt erlaubt.

In letzter Zeit ist eine zunehmende Zahl von portablen Systemen auf den Markt gekommen, wie z.B. Mobiltelefone, Palm-Top-Computer und Geräte aus der Medizintechnik (z.B. Hörgeräte). Die Spannungsversorgung dieser Systeme wird mit Batterien oder Akkumulatoren bewerkstelligt. Die Betriebszeit bzw. Standzeit von portablen Geräten hängt dann zum einen von der Kapazität der Batterie ab, zum anderen von der Leistungsaufnahme der Systemkomponenten. Im Falle der mikroelektronischen Schaltungen wurden bereits Konzepte zur Reduzierung der Leistungsaufnahme entwickelt, um damit die Standzeit zu verlängern [1].

Die Leistungsaufnahme von mikroelektronischen Schaltungen läßt sich im wesentlichen durch die folgenden Beziehung beschreiben:

$$P \propto \left( \sum_i \sigma_i \bullet C_i \right) \bullet \text{VDD} \bullet \text{HUB} \qquad (1)$$

mit $\sigma_i$ als Schalthäufigkeit des i-ten Knotens, $C_i$ als dessen Kapazität, VDD stellt die Versorgungsspannung dar, HUB die Pegeländerung eines Knotens (in statischer CMOS-Logik gilt meist HUB = VDD), i durchläuft alle Knoten der betreffenden Schaltung.

Aus Gleichung (1) lassen sich folgende Maßnahmen zur Leistungsreduzierung ableiten: Absenkung der Versorgungsspannung, Reduzierung von Knotenkapazitäten und Schalthäufigkeiten.

Im Falle eines SRAM-Speichers sind Schaltungen realisiert worden, die mittels der obengenannten Maßnahmen bereits eine deutlich reduzierte Leistungsaufnahme aufweisen: Absenkung der Versorgungsspannung von 5 Volt auf 3.3 Volt (z.T. 2.4 V), Vorladen der Bitleitungen auf VDD/2 statt auf VDD (Hubreduzierung), Minimierung der Kapazität durch ein kompaktes Layout (d.h. geringe Transistorenzahl und geringe Verdrahtungskapazitäten), und durch eine Einteilung des Speichers in Blöcke, die damit einzeln angesteuert werden können (d.h. reduzierte Schalthäufigkeit).

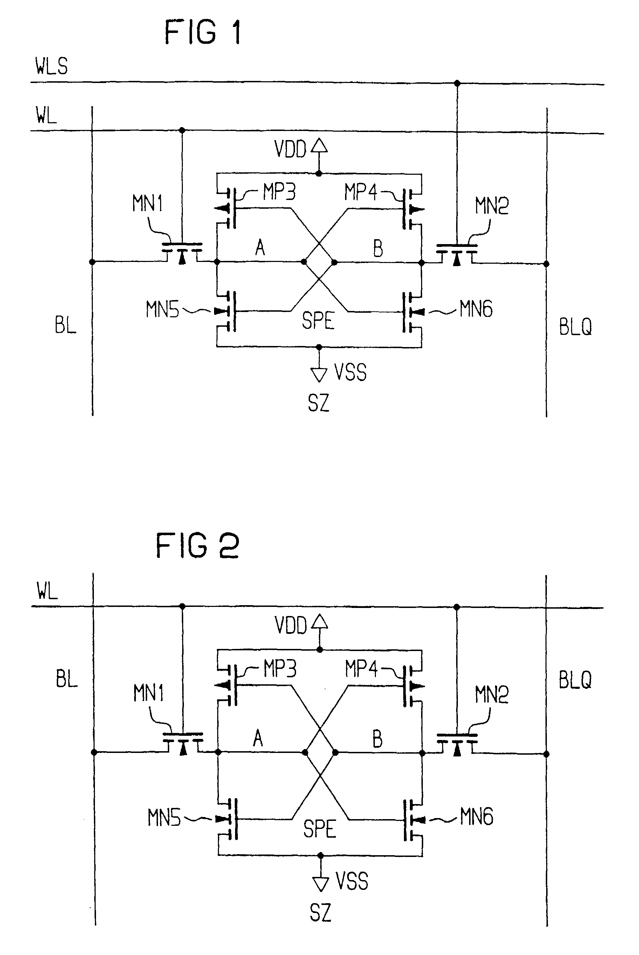

Aus [2] ist eine 6- Transistor- Speicherzelle bekannt, die auch in Fig.2 dargestellt ist. Die Speicherzelle SZ besteht aus zwei rückgekoppelten Invertern MN5, MP3 bzw. MN6, MP4. Der Inverter MN5, MP3 ist mit seinem Ausgangsknoten A über einen ersten Auswahltransistor MN1 mit einer ersten Bitleitung BL verbunden, der über eine Wortleitung WL angesteuert wird. Der Inverter MN6, MP4 ist mit seinem Ausgangsknoten B über einen zweiten Auswahltransistor MN2 an eine zweite Bitleitung BLQ angeschlossen, der ebenfalls von der Wortleitung WL angesteuert wird. Die entsprechenden Transistoren der beiden Inverter haben gleiche Dimensionen, d.h. MP3=MP4 und MN5=MN6.

Ein wichtiges Merkmal eines SRAMs, aufgebaut mit der beschriebenen 6-Transistor-Speicherzelle (Fig.2) und differentiell arbeitenden Leseverstärkern (siehe [2]), stellt die paarweise Ansteuerung von Bitleitungen dar. Beim Schreiben werden BL und BLQ entsprechend dem Datum mit zueinander komplementären Pegeln belegt (z.B. BL=1 und BLQ=0); nur dann kann das rückgekoppelte Inverterpaar (bestehend aus MN5, MN6, MP3 und MP4) über die durch WL durchgesteuerten Auswahltransistoren MN1 und MN2 umgeschaltet werden ( A von 0 auf 1; B von 1 auf 0). Zu Beginn eines Lesevorgangs werden beide Knoten BL und BLQ auf gleiches Potential gelegt, um dann von einer angesteuerten Speicherzelle (MN1 und MN2 durch WL sind auf Durchlaß geschaltet) auf zueinander komplementäre Pegel gezogen zu werden. Ein differentiell arbeitender Leseverstärker erlaubt dann eine schnelle Bewertung der Differenz zwischen BL und BLQ und damit ein sicheres Lesen.

Die Kapazitäten der Bitleitungen BL und BLQ werden sowohl durch die kapazitive Belastung einer Zelle als auch durch die Architektur des Speichers bestimmt, im allgemeinen gehören sie zu den größten Kapazitäten eines SRAMs. Da je angesteuerter Speicherzelle sowohl beim Lese- als auch beim Schreibvorgang in jedem Fall eine der großen Bitleitungskapazitäten umgeladen wird ($\sigma$BL=0.5, $\sigma$BLQ=0.5, s.Formel (1)), wird an dieser Stelle ein Großteil der Leistungsaufnahme eines SRAMs verursacht.

Eine Reduzierung der Schalthäufigkeit von Bitleitungen kann dementsprechend zu einer deutlichen Minderung der SRAM-Leistungsaufnahme führen.

Aus [3] ist eine 6- Transistor- Speicherzelle bekannt, die auch in Fig.1 dargestellt ist.Die Speicherzelle SZ besteht aus einem Speicherelement SPE aus zwei unterschiedlich dimensionierten, rückgekoppelten Invertern MN5, MP3 bzw. MN6, MP4. Der schwächere Inverter MN5, MP3 ist mit seinem Ausgangsknoten A über einen ersten Auswahltransistor MN1 mit einer ersten Bitleitung BL verbunden, der über eine Wortleitung WL angesteuert wird. Der stärkere Inverter MN6, MP4 ist mit seinem Ausgangsknoten B über einen zweiten Auswahltransistor MN2 an eine zweite Bitleitung BLQ angeschlossen, der von einer zweiten Wortleitung WLS angesteuert wird.

Bei der bekannten Schaltung dient die Wort leitung WL zum Schreiben eines Bit, die zweite Wortleitung WLS zum Lesen eines Bit aus dem Speicherelement SPE mit einem einpoligen Leseverstärker. VDD und VSS sind Versorgungsspannungen. Beim Lesen dieser SRAM-Zelle erfährt nur die Bitleitung BL eine Pegeländerung, beim Schreiben nur die Bitleitung BLQ. Die Schalthäufigkeit der Bitleitungen konnte damit deutlich reduziert werden.

Wird zur Reduzierung der Leistungsaufnahme die Versorgungsspannung VDD auf

$$|Vthmax| < VDD < |Vthp| + |Vthn| \qquad (2)$$

abgesenkt (Vthp, Vthn: Einsatzspannung des N(P)-Kanal-Transistors, Vthmax der größere Wert von Vthp und Vthn ), ist die Funktion der Speicherzelle nach [3] (Fig.1) nicht gewährleistet. Beim Schreiben einer 1 (BL= VDD) wird der Knoten A nur auf V= VDD-Vthn umgeladen, da über den Auswahltransistor MN1 ein Spannungsabfall ΔV von ΔV= Vthn auftritt. Der Inverter bestehend aus MP4 und MN6 kann bei diesem Spannungspegel am Knoten A nicht umschalten, eine Speicherung findet damit nicht statt. Der Einsatz der Speicherzelle nach [3] (Fig.1) im Spannungsbereich nach (2) ist nicht möglich.

Das der Erfindung zugrunde liegende Problem besteht darin, den Betrieb einer aus Speicherzellen nach Fig. 1 bestehenden SRAM-Architektur anzugeben, mit deren Hilfe eine möglichst niedrige Schaltaktivität der Bitleitungen beibehalten wird, gleichzeitig aber die Funktion bei niedrigen Versorgungsspannungen gewährleistet wird.

Dieses Problem wird mit einem Verfahren nach Patentanspruch 1 gelöst.

Weiterbildungen der Erfindung ergeben sich aus den abhängigen Ansprüchen.

Anhand von Figuren wird die Erfindung weiter erläutert. Es zeigen

Figur 1, 2        die bereits erwähnten Speicherzellen,
Figur 3        ein Diagramm, das die Spannungsverhältnisse beim Lesevorgang darstellt,
Figur 4        ein Diagramm, das die Spannungsverhältnisse beim Schreibvorgang darstellt,
Figur 5        eine Ausführung des Speichers,
Figur 6        einen Zeilendekoder.

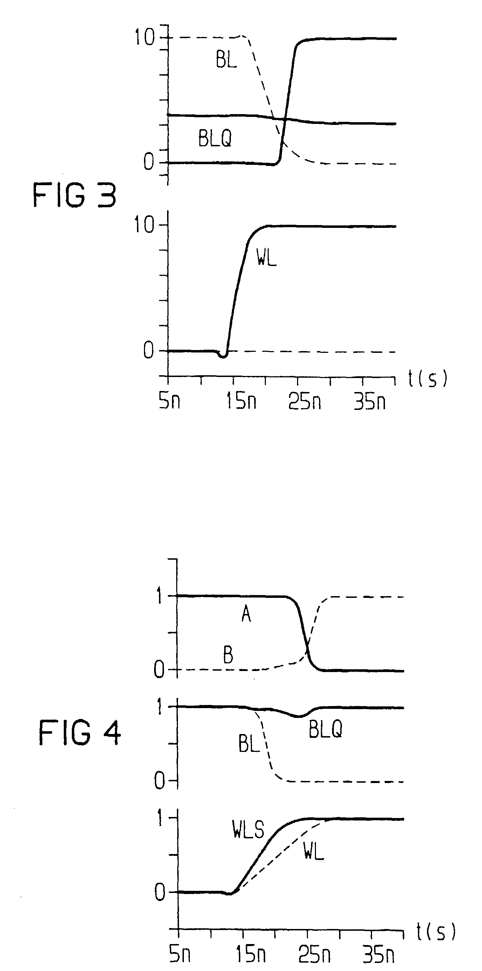

Die in Fig.1 dargestellte SRAM-Zelle wird durch die zwei Wortleitungen WLS und WL angesteuert. Beim Lesevorgang wird wie bei [3] nur WL aktiv, wobei der Transistor MN1 auf Durchlaß geschaltet wird. Ist eine Null gespeichert (A=0, B=1), wird die auf 1 vorgeladene Bitleitung BL auf 0 gezogen. Ist in der Zelle eine 1 gespeichert (A=VDD, B=0) verbleibt BL auf dem Vorladepotential. Bei beiden Werten erfährt die Bitleitung BLQ während des gesamten Lesevorgangs keine Pegeländerungen. Beim Lesevorgang beträgt die Schalthäufigkeit der Bitleitungen BL und BLQ deshalb σBL=0.5 bzw. σBLQ=0, d.h., die Schalthäufigkeit von BLQ wurde auf 0 reduziert, gegenüber σBLQ=0.5 bei einer SRAM-Zelle (Fig.2) mit der Ansteuerung durch eine Wortleitung WL. In Fig.3 ist das Ergebnis einer Simulation des Vorgangs beim Lesen einer 0 gezeigt. WL wird durch einen Zeilendekoder auf 1 umgeladen (WLS verbleibt auf 0), wodurch BL durch die Zelle gegen 0 gezogen wird.

Dadurch wird der Ausgang LS eines einpoligen Leseverstärkers, hier ein statischer CMOS-Inverter, auf 1 umgeladen.

Beim Schreibvorgang (Fig.4) legt der Zeilendekoder im Unterschied zu [3] beide Wortleitungen WL und WLS auf VDD. Das Datum wird in komplementären Pegeln auf die Bitleitungen gelegt (z. B. BL=VSS, BLQ=VDD). Damit ändert sich der Zustand des rückgekoppelten Inverterpaares und das Potential des Knoten A wechselt von VDD auf VSS (B von VSS auf VDD). Damit ist in die Speicherzelle eine Null eingeschrieben worden (Inhalt zuvor war eine Eins).

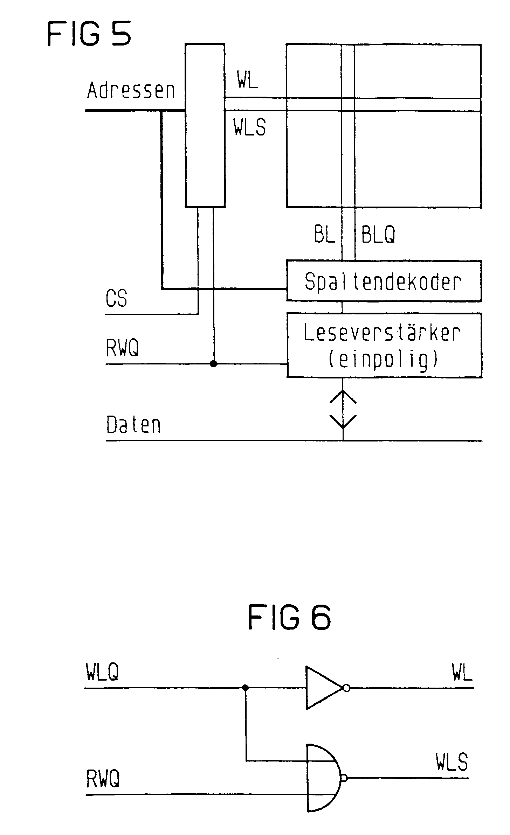

In Fig.5 ist die SRAM-Architektur entsprechend der vorgeschlagenen Version schematisch dargestellt. Dem Zeilendekoder ZD muß in der SRAM-Architektur das Schreib-Lese-Signal RWQ zugeführt werden. Mit SD ist ein Spaltendekoder, mit LV ein einpoliger Leseverstärker, mit CS ein Chip- select Signal, mit SP eine Speichermatrix bezeichnet.

In Fig.6 ist eine Realisierung des modifizierten Zeilendekoders ZD vorgestellt.Die Figur ist aus sich heraus verständlich.

Literaturnachweis:

[1] A.P.Chandrakasan, S.Sheng, R.W.Brodersen: "Low-Power CMOS Digital Design", IEEE Journal of Solid-State Circuits, Vol.27, No.4, April 1992, S.473-484.
[2] D.Rhein, H.Freitag: "Mikroelektronische Speicher", Springer Verlag 1992, S. 50- 51, 56- 57
[3] IBM Technical Disclosure Bulletin Vol.31, No.1 June 1988, S. 291

**Patentansprüche**

1. Verfahren zum Betrieb einer SRAM MOS- Transistor Speicherzelle (SZ) bestehend aus

   - einem Speicherelement (SPE) aus einem rückgekoppelten Inverterpaar (MN5, MP3; MN6, MP4),
   - aus einem ersten an eine erste Wortleitung (WL) angeschlossenen Auswahltransistor (MN1), der den Anschlußknoten (A) des ersten Inverters (MN5, MP3) mit einer ersten Bitleitung (BL) verbindet,
   - einem zweiten an eine zweite Wortleitung (WLS) angeschlossenen Auswahltransistor (MN2), der den Anschlußknoten (B) des zweiten Inverters (MN6, MP4) mit einer zweiten Bitleitung (BLQ) verbindet,

   bei dem beim Schreiben einer Information in das Speicherelement (SPE) beide Auswahltransistoren (MN1, MN2) leitend gesteuert werden, und
   bei dem beim Lesen des Inhaltes des Speicherelementes (SPE) der erste Auswahltransistor (MN1) leitend gesteuert wird, dadurch gekennzeichnet, daß beim Lesen des Inhaltes des Speicherelementes (SPE) der zweite Auswahltransistor (MN2) im gesperrten Zustand bleibt.

2. Verfahren nach Anspruch 1,

   bei dem die Versorgungsspannung VDD der Speicherzelle in den Bereich

   $$|Vthmax| < VDD < |Vthp| + |Vthn|$$

   gelegt wird,
   wobei |Vthp| und |Vthn| die Beträge der Einsatzspannungen der Transistoren sind, und |Vthmax| der größere der beiden Werte ist.

**Claims**

1. Method for operating a SRAM MOS transistor memory cell (SZ) comprising

   - a memory element (SPE) composed of an inverter pair (MN5, MP3; MN6, MP4) with feedback,
   - a first selection transistor (MN1) which is connected to a first word line (WL) and connects the connecting node (A) of the first inverter (MN5, MP3) to a first bit line (BL),
   - a second selection transistor (MN2) which is connected to a second word line (WLS) and connects the connecting node (B) of the second inverter (MN6, MP4) to a second bit line (BLQ),

   in the case of which both selection transistors (MN1, MN2) are switched on when writing information to the memory element (SPE) and
   in the case of which the first selection transistor (MN1) is switched on when reading the content of the memory element (SPE), characterized in that the second selection transistor (MN2) remains switched off when reading the content of the memory element (SPE).

2. Method according to Claim 1,
   in the case of which the supply voltage VDD of the memory cell is set in the range

$$|Vthmax| < VDD < |Vthp| + |Vthn|$$

|Vthp| and |Vthn| being the magnitudes of the threshold voltages of the transistors, and |Vthmax| being the greater of the two values.

**Revendications**

1. Procédé d'actionnement d'une cellule de mémoire SRAM à transistors MOS (SZ) se composant

   - d'un élément de mémoire (SPE) composé d'une paire rétroactive d'inverseurs (MN5, MP3 ; MN6, MP4),
   - d'un premier transistor de sélection (MN1) relié à un premier conducteur de mot (WL), qui relie le noeud de connexion (A) du premier inverseur (MN5, MP3) à un premier conducteur de bit (BL),
   - d'un deuxième transistor de sélection (MN2) relié à un deuxième conducteur de mot (WLS), qui relie le noeud de connexion (B) du deuxième inverseur (MN6, MP4) à un deuxième conducteur de bit (BLQ),

   pour lequel, lors de l'écriture d'une information dans l'élément de mémoire (SPE), les deux transistors de sélection (MN1, MN2) sont actionnés en mode passant, et pour lequel, lors de la lecture du contenu de l'élément de mémoire (SPE), le premier transistor de sélection (MN1) est actionné en mode passant, caractérisé en ce que lors de la lecture du contenu de l'élément de mémoire (SPE), le deuxième transistor de sélection (MN2) reste dans l'état bloqué.

2. Procédé selon la revendication 1,
   pour lequel la tension d'alimentation VDD de la cellule de mémoire est comprise dans le domaine

$$|Vthmax| < VDD < |Vthp| + |Vthn|$$

| Vthp | et | Vthn | étant les valeurs des tensions de charge des transistors, et | Vthmax | étant la plus grande des deux valeurs.

## FIG 1

WLS

WL

MN1

MP3    MP4    MN2

VDD

A    B

MN5    MN6

BL    SPE    BLQ

VSS

SZ

## FIG 2

WL

BL    BLQ

MP3    MP4

VDD

MN1    MN2

A    B

MN5    MN6

SPE

VSS

SZ

FIG 3

FIG 4

## FIG 5

## FIG 6